# EUROPÄISCHE PATENTANMELDUNG

(11) **EP 4 418 678 A1**
(43) Veröffentlichungstag der Anmeldung: **21.08.2024**
(21) Anmeldenummer: 23157155.5
(22) Anmeldetag: 17.02.2023
(51) Int. Cl.: H04Q 1/02, H05K 7/14

(54) **MODULARES HALTERMODUL, SCHALTSCHRANK, MONTAGEVERFAHREN**

(71) Anmelder: Siemens Aktiengesellschaft, 80333 München (DE)
(72) Erfinder: Wager, Adrian, 92353 Postbauer-Heng (DE)
(74) Vertreter: Siemens Patent Attorneys

(57) **Zusammenfassung**

Die Erfindung betrifft ein modulares Haltermodul (MHM) für elektrische Komponenten (CMP) in einem Schaltschrank (RCK), insbesondere für einen Umrichter eines elektrischen Antriebs, wobei die elektrischen Komponenten (CMP) mittels des Haltermoduls (MHM) an einer Seitenbegrenzung (SWL) des Schaltschranks (RCK) befestigbar sind.

Zur Verbesserung des Schaltschrankes und des Montageprozesses wird vorgeschlagen, dass das Haltermodul (MHM) ein erstes Element (FEL) aufweist, an dem mindestens eine elektrische Komponente (CMP) anbringbar ist und das Haltermodul (MHM) ein zweites Element (SEL) aufweist, das an einer Seitenbegrenzung (SWL) des Schaltschranks (RCK) anbringbar ist, wobei das zweite Element (SEL) und das erste Element (FEL) als Kontaktbereiche (CTS) zueinander korrespondierende Ausformungen (FRT) und/oder Aufnahmen (CTT) aufweisen, die ineinandergreifend ausgebildet sind, so dass das erste Element (FEL) gegen eine Bewegung entgegen einer ersten Längsrichtung (LTD) des Haltermoduls (MHM) abgestützt ist und gegen eine Bewegung entlang einer ersten Querrichtung (CRD) zur ersten Längsrichtung (LTD) durch das Ineinandergreifen der Ausformungen (FRT) und/oder Aufnahmen (CTT) gehindert ist. Daneben betrifft die Erfindung ein Montageverfahren und einen Schaltschrank (RCK).

## Beschreibung

Die Erfindung betrifft ein modulares Haltermodul für elektrische Komponenten in einem Schaltschrank, insbesondere für einen Umrichter eines elektrischen Antriebs, wobei die elektrischen Komponenten mittels des Haltermoduls an einer Seitenbegrenzung des Schaltschranks befestigbar sind. Daneben betrifft die Erfindung ein Montageverfahren und einen Schaltschrank.

Herkömmliche Schaltschränke und Montageverfahren sehen vor, dass elektrische Komponenten der Schaltschränke an sogenannten Hutschienen in dem Schaltschrank direkt befestigt werden. Hierzu werden auch sogenannte Montageplatten eingesetzt, an denen die Komponenten befestigt werden. Diese Montageplatten können an Gerüsten in dem Schaltschrank an Zwischenplatten bzw. an Schrankholmen verschraubt werden.

Schon bei der Erstmontage erfolgt das Einsetzen der elektrischen Komponenten häufig in einer bestimmten Reihenfolge, weil die Anordnung teilweise keine Variation der Montageschritte zulässt. Diese Einschränkung verhindert die parallele Ausführung vieler Montageschritte.

Problematischer als die Erstmontage ist der Servicefall bei herkömmlichen Schaltschränken. Bei einem vollständig ausgebauten Schaltschrank müssen in der Regel viele elektrische Komponenten aus dem Schaltschrank entfernt werden, um eine bestimmte Komponente auszutauschen.

Ausgehend von den Problemen und Nachteilen des Standes der Technik hat es sich die Erfindung zur Aufgabe gemacht an, ein Haltermodul eingangs definierter Art derart weiterzubilden, sodass die erläuterten Probleme und Nachteile vermieden werden.

Zur erfindungsgemäßen Lösung der Aufgabe wird ein Haltermodul eingangs definierter Art mit den zusätzlichen Merkmalen des Kennzeichens des unabhängigen Anspruchs 1 vorgeschlagen. Daneben schlägt die Erfindung einen Schaltschrank und ein entsprechendes Montageverfahren vor. Die jeweils abhängigen Unteransprüche beinhalten vorteilhafte Weiterbildungen der Erfindung.

Im Einzelnen wird das eingangs definierte Haltermodul erfindungsgemäß fortgebildet, indem vorgesehen ist,
- dass das Haltermodul ein erstes Element aufweist, an dem mindestens eine elektrische Komponente anbringbar ist und
- dass das Haltermodul ein zweites Element aufweist, das an einer Seitenbegrenzung des Schaltschranks anbringbar ist,
- wobei das zweite Element und das erste Element als Kontaktbereiche zueinander korrespondierende Ausformungen und/oder Ausnehmungen aufweisen, die ineinandergreifend ausgebildet sind, so dass das erste Element gegen eine Bewegung entgegen einer ersten Längsrichtung des Haltermoduls abgestützt ist und gegen eine Bewegung entlang einer ersten Querrichtung zur ersten Längsrichtung durch das Ineinandergreifen der Ausformungen und/oder Ausnehmungen gehindert ist.

Die erste Längsrichtung ist hierbei bezogen auf den Schaltschrank die Vertikalerstreckung in einer betriebsfertigen Sollposition. Diese Vertikalerstreckung bzw. erste Längsrichtung kann hierbei als die Gegenrichtung zur Schwerkraftrichtung angesehen werden. Bezüglich des Haltermoduls wird der Begriff "erste Längserstreckung" benutzt, weil das Haltermodul grundsätzlich nur im betriebsfertigen montierten Zustand eine entsprechende Ausrichtung zur Schwerkraft aufweist und ansonsten beliebig im Raum orientiert sein kann.

Das erfindungsgemäße modulare Haltermodul weist eine besondere Modularität auf. Diese Modularität ermöglicht ein Verfahren zur Montage elektrischer Komponenten in einen Schaltschrank mit den Schritten:
- Befestigen des zweiten Elements in dem Schaltschrank,
- Befestigen der mindestens einen elektrischen Komponente an dem ersten Element,
- Anbringen des ersten Elements umfassend die mindestens eine elektrische Komponente an dem zweiten Element.

Eine vorteilhafte Weiterbildung sieht vor, dass ein Kontaktbereich des zweiten Elements als eine im Wesentlichen sich entlang einer zweiten Querrichtung zur ersten Längsrichtung erstreckende Schiene ausbildet ist, an der das erste Element mit seinem Kontaktbereich im zusammengesetzten Zustand verschieblich ist, wobei die erste Querrichtung und die zweite Querrichtung und die erste Längsrichtung jeweils zueinander senkrecht sind. Auf diese Weise können an ersten Elementen montierte elektrische Komponenten entlang der ersten Querrichtung - d. h. in Tiefenrichtung des Schaltschranks - verschoben werden. Beispielsweise können elektrische Komponenten mit ersten Elementen des Haltermoduls einzeln in zweite Elemente des Haltermoduls eingehängt werden und in Tiefenrichtung nacheinander in den Schaltschrank eingeschoben werden.

Grundsätzlich ist es möglich, dass mehrere erste Elemente des Haltermoduls einem einzigen zweiten Element zugeordnet werden bzw. an einem einzigen zweiten Element des Haltermoduls angebracht werden.

Andere vorteilhafte Weiterbildung sieht vor, dass das erste Element als Ausformung ein Formelement aufweist, das derart ausgebildet ist, dass es den Kontaktbereich des zweiten Elements, der als Kante ausgebildet ist, im zusammengesetzten Zustand zumindest teilweise umschließt. Eine Möglichkeit die Umsetzung dieser Ausgestaltung ist gegeben dadurch, dass das Formelement als umgekehrtes U-Profil ausgebildet ist, das die Kante des Kontaktbereichs des zweiten Elements im zusammengesetzten Zustand zumindest teilweise umschließt. Beim Zusammenbau wird das umgekehrte U Profil des ersten Elements wie ein Haken an dem Kontaktbereich des zweiten Elements ein gehakt und auf diese Weise gegen die Schwerkraft in dem Schaltschrank gesichert.

Eine andere Möglichkeit diesen Effekt gegen die Schwerkraft dem Schaltschrank zu erreichen, ergibt sich dadurch, dass das erste Element als zweite Ausformung eine beginnend an einer quer verlaufenden Kante schräg aus der Ebene herausragende Fortsetzung aufweist, die an einer Endkante endet, derart, dass die schräge Fortsetzung im zusammengesetzten Zustand durch die zweite Aufnahme hindurch ragt.

Grundsätzlich ist es nach einer vorteilhaften Weiterbildung sinnvoll, wenn das erste Element einen ersten flächigen Bereich aufweist, und das zweite Element einen zweiten flächigen Bereich aufweist, so dass im zusammengesetzten Zustand sich der erste flächige Bereich und der zweite flächige Bereich im Wesentlichen parallel zueinander erstrecken. Eine derartige Anlage des ersten Elementes an dem zweiten Element ermöglicht auch eine elektrische Erdung. Zu diesem Zweck können an den flächigen Elementen dezidierte elektrische Kontakte bzw. Anlageflächen vorgesehen sein, die derart ausgebildet sind, dass sich in dem zusammengesetzten Zustand des Haltermoduls eine elektrisch leitende Verbindung zwischen dem ersten Element und dem zweiten Element ergibt. Diese Kontakte können gegeneinander federnd ausgebildet sein.

Besonders zweckmäßig sieht eine vorteilhafte Weiterbildung vor, dass das erste Element einen dritten flächigen Bereich aufweist, der sich beginnend an einer sich in die erste Längsrichtung erstreckenden Kante etwa senkrecht zu dem ersten flächigen Bereich erstreckt. Hierbei ist es insbesondere sinnvoll, wenn an dem dritten flächigen Bereich Vorkehrungen vorgesehen sind zur Befestigung elektrischer Komponenten. Diese Vorkehrungen können Bohrungen sein, die eine Befestigung der elektrischen Komponenten mittels Schrauben oder Nieten ermöglichen. Alternativ können als Vorkehrungen sogenannte Hutschienen vorgesehen sein, an denen die elektrischen Komponenten standardisiert befestigt werden können.

Eine besonders einfache und zweckmäßige Ausbildung des erfindungsgemäßen Haltermoduls sieht vor, dass ein Kontaktbereich des zweiten Elements als gerader Kantenabschnitt einer Aufnahme oder Ausnehmung in einem sich flächig ersteckenden Abschnitt des zweiten Elements ausgebildet ist. Zweckmäßig können diese Ausnehmungen oder Aufnahmen rechteckig sein. Hierbei ist es sinnvoll, wenn sich die rechteckige Form länger in Querrichtung erstreckt als in Längsrichtung bzw. bezogen auf den Schaltschrank die Aufnahme bzw. Ausnehmung in Tiefenrichtung des Schaltschranks ein längliches Rechteck ist.

Besonders zweckmäßig lässt sich die Erfindung umsetzen, wenn das erste Element und/oder das zweite Element als Blechbauteile ausgebildet sind.

Akte Weiterbildung sieht eine konkrete Ausführungsformen der Erfindung vor, dass das zweite Element und das erste Element jeweils mindestens zwei als Kontaktbereiche zueinander korrespondierende Ausformungen und/oder Aufnahmen, insbesondere Ausnehmungen aufweisen,
wobei eine erste Aufnahme in dem zweiten Element vorgesehen ist,
wobei eine zweite Aufnahme in dem zweiten Element vorgesehen ist,
wobei eine erste Ausformung an dem ersten Element vorgesehen ist, die zu der ersten Aufnahme an dem zweiten Element korrespondiert
wobei eine zweite Ausformung an dem ersten Element vorgesehen ist, die zu der zweiten Aufnahme an dem zweiten Element korrespondiert
wobei das erste Element als erste Ausformung ein umgekehrtes U-Profil aufweist korrespondierend zu einer geraden Kante der ersten Aufnahme,
wobei das erste Element als zweite Ausformung eine beginnend an einer quer verlaufenden Kante schräg aus der Ebene herausragende Fortsetzung aufweist, die an einer Endkante endet, derart, dass die schräge Fortsetzung im zusammengesetzten Zustand durch die zweiten Aufnahme hindurch ragt.

Eine weitere vorteilhafte Ausgestaltung der Erfindung sieht zur Erhöhung der Stabilität vor, dass mindestens eine der Aufnahmen in dem zweiten Element gegenüberliegend von dem Kontaktbereich eine Kante mit einer sich von der Kante und dem ersten Element sich fort erstreckende Versteifungsrippe aufweist, derart, dass der zweite flächige Bereich des zweiten Elements durch diese Versteifungsrippe versteift wird. Vielleicht Bauteil ist dieser Ausgestaltung besonders zweckmäßig, weil das Material, das zur Herstellung der Aufnahme bzw. Ausnehmung entfernt werden muss, gleichzeitig durch eine Biegung aus der Ebene der flächigen Erstreckung des zweiten Elementes heraus die Versteifungsrippe ausbildet.

Nachdem es im Rahmen der Montage möglich ist, das erste Element in das zweite Element einzuhängen bzw. gegen die Schwerkraft in dem Schaltschrank abzustützen und gleichzeitig in eine Querrichtung zu fixieren, ist es sinnvoll, wenn an dem ersten Element und dem zweiten Element Vorkehrungen zur Sicherung des ersten Elements gegen ein Verschieben in die zweite Querrichtung und gegen einen Versatz in die erste Längsrichtung vorgesehen sind. Auf diese Weise kann das erste Element an dem zweiten Element in Tiefenrichtung des Schaltschranks gesichert werden. Vorzugsweise werden hierfür Bohrungen vorgesehen, die zueinander fluchten und den Einsatz eines Sicherungselements, beispielsweise einer Schraube, ermöglichen. Wenigstens eine der beiden Bohrungen kann hierbei als Gewindebohrung ausgebildet sein. Wenn die Bohrung in dem zweiten Element als Gewindebohrung ausgebildet ist und in dem ersten Element als Durchgangsbohrung, ist es möglich, neben der formschlüssigen Fixierung mittels der Verschraubung auch einen Reibschluss zwischen den beiden Elementen zu erzielen, so dass sich eine spielfreie Montage ergibt.

Im Folgenden ist die Erfindung anhand eines speziellen Ausführungsbeispiels zur Verdeutlichung näher beschrieben. Es zeigen jeweils schematisch, vereinfacht:
- Figur 1: eine 3-dimensionale Darstellung eines Schaltschranks nach der Erfindung,
- Figur 2: eine 3-dimensionale Darstellung eines Haltermoduls mit einer elektrischen Komponente,
- Figur 3: verschiedene 3-dimensionale Darstellungen von elektrischen Komponenten jeweils montiert an einem ersten Element eines Haltermoduls,
- Figur 4: die verschiedenen elektrischen Komponenten der Figur 3 gemeinsam angebracht an einem zweiten Element eines Haltermoduls,
- Figur 5: zwei Details ausgewiesen in Figur 4 in einer ersten Ausführungsform im Querschnitt,
- Figur 6: eine 3-dimensionale Darstellung eines ersten Elements angebracht an einem zweiten Element eines Haltermoduls in einer zweiten Ausführungsform,
- Figur 7: ein Detail ausgewiesen in Figur 6 in einer zweiten Ausführungsform im Querschnitt,
- Figur 8: eine 3-dimensionale Darstellung eines ersten Elements eines Haltermoduls,
- Figur 9: eine 3-dimensionale Darstellung eines zweiten Elements eines Haltermoduls.

Die oben beschriebenen Eigenschaften, Merkmale und Vorteile dieser Erfindung sowie die Art und Weise, wie sie erreicht werden, werden im Lichte der folgenden Beschreibung und Ausführungsformen, die im Kontext der Zeichnungen näher beschrieben werden, klarer und verständlicher. Diese nachfolgende Beschreibung beschränkt die Erfindung nicht auf die enthaltenen Ausführungsformen. Gleiche Komponenten oder Teile können mit den gleichen Referenzzeichen in verschiedenen Bildern gekennzeichnet werden. Im Allgemeinen sind die Zahlen nicht für den Maßstab. Es versteht sich, dass eine bevorzugte Ausführungsform der vorliegenden Erfindung auch eine beliebige Kombination der abhängigen Ansprüche oder darüber liegenden Ausführungsformen mit dem jeweiligen unabhängigen Anspruch sein kann.

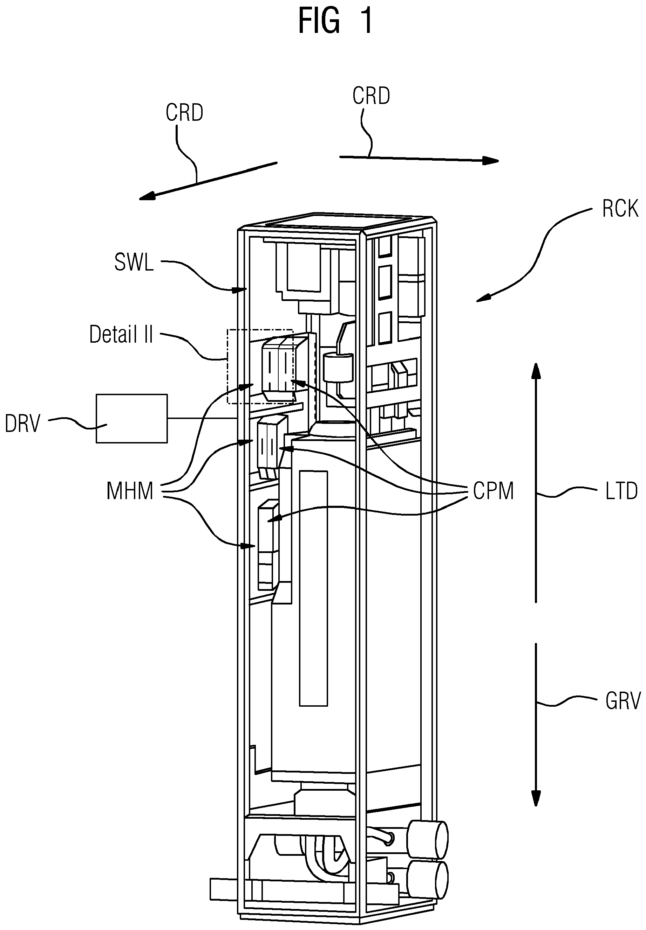

Figur 1 zeigt einen Schaltschrank RCK für elektrische Komponenten CMP für einen Umrichter eines elektrischen Antriebs DRV. Elektrische Komponenten CMP sind mittels eines Haltermoduls MHM an einer Seitenbegrenzung SWL des Schaltschranks RCK befestigt. Die Seitenbegrenzung SWL ist in der Figur 1 nur gerüstartig dargestellt. In der Praxis befinden sich an den dargestellten Streben des Gerüsts äußere Seitenwände, die den Schaltschrank RCK derart verschließen, dass beispielsweise ein Eindringen von Schmutz verhindert wird. Der Schaltschrank RCK wird im betriebsfertigen Zustand derart aufgestellt, dass er sich vertikal entlang einer ersten Längsrichtung LTD erstreckt, wobei die erste Längsrichtung LTD der Schwerkraft GRV bei korrekt ausgerichteter Aufstellung des Schaltschranks RCK im Wesentlichen entgegengesetzt ist. In Tiefenrichtung und in Breitenrichtung erstrecken sich eine erste Querrichtung CRD zu der ersten Längsrichtung LTD und eine zweite Querrichtung CRD zu der ersten Längsrichtung LTD. Dieser Bezug gilt vorliegend für alle Angaben zu Bauelementen des Schaltschranks RCK.

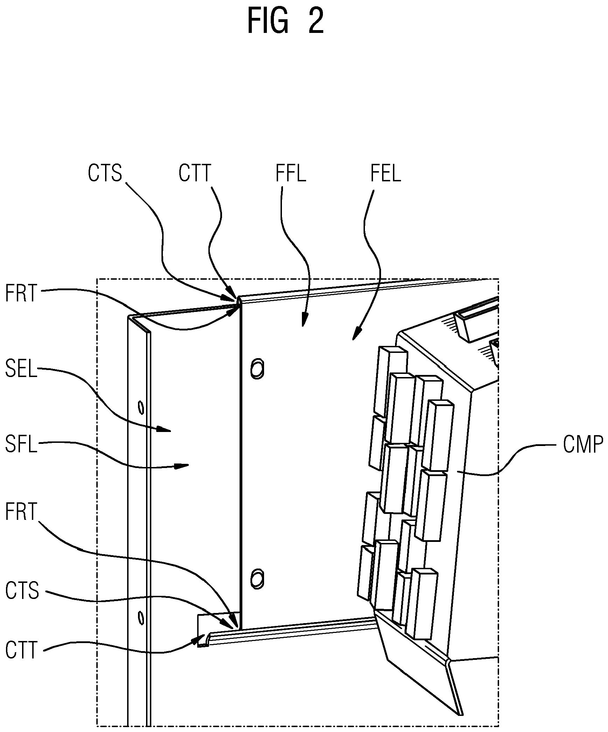

Figur 2 zeigt als Detail aus der Figur 1 Teile eines erfindungsgemäßen Haltermoduls MHM, dass eine elektrische Komponente CMP in dem Schaltschrank RCK zunächst gegen die Schwerkraft GRV abstützt. Die elektrische Komponente CMP ist an einem ersten Element FEL des Haltermoduls MHM befestigt, wobei das erste Element FEL an einem zweiten Element SEL durch ein Einhaken in einem Kontaktbereich CTS derart angebracht ist, dass es gegen eine Bewegung entgegen der ersten Längsrichtung LTD - also gegen die Schwerkraft GRV - abgestützt ist und außerdem gegen eine Bewegung entlang der ersten Querrichtung CRD - also gegen eine Bewegung in Breitenrichtung des Schaltschranks RCK - durch das Ineinandergreifen von Ausformungen FRT und *Aufnahmen CTT* in Kontaktbereichen CTS des ersten Elements SEL zu dem zweiten Element SEL gehindert ist.

Das erste Element FEL weist einen ersten flächigen Bereich FFL auf und das zweite Element SEL weist einen zweiten flächigen Bereich SFL auf, so dass im zusammengesetzten Zustand sich der erste flächige Bereich FFL und der zweite flächige Bereich SFL im Wesentlichen parallel zueinander erstrecken. Hier sei angemerkt, dass die erste Querrichtung CRD sich grundsätzlich im zusammengesetzten Zustand entlang einer Flächennormalen der flächigen Erstreckung des ersten flächigen Bereichs FFL bzw. des parallelen zweite flächige Bereichs SFL erstreckt.

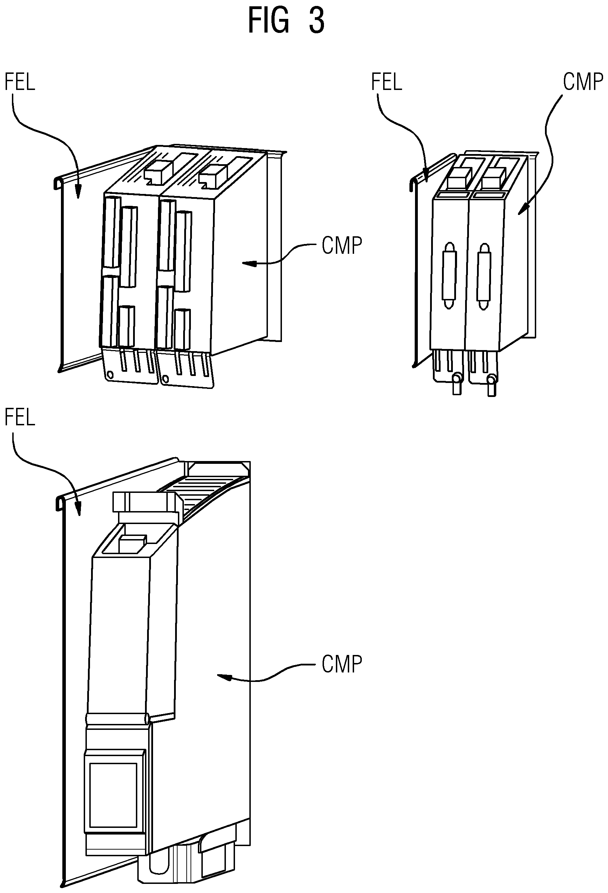

Figur 3 zeigt drei verschiedene elektrische Komponenten CMP die jeweils an ebenfalls unterschiedlich ausgebildeten ersten Elementen FEL befestigt sind. Die drei ersten Elemente FEL sind an die Größe und die Form der elektrischen Komponenten CMP angepasst aber weisen jeweils den gleichen grundsätzlichen oder qualitativen Aufbau auf.

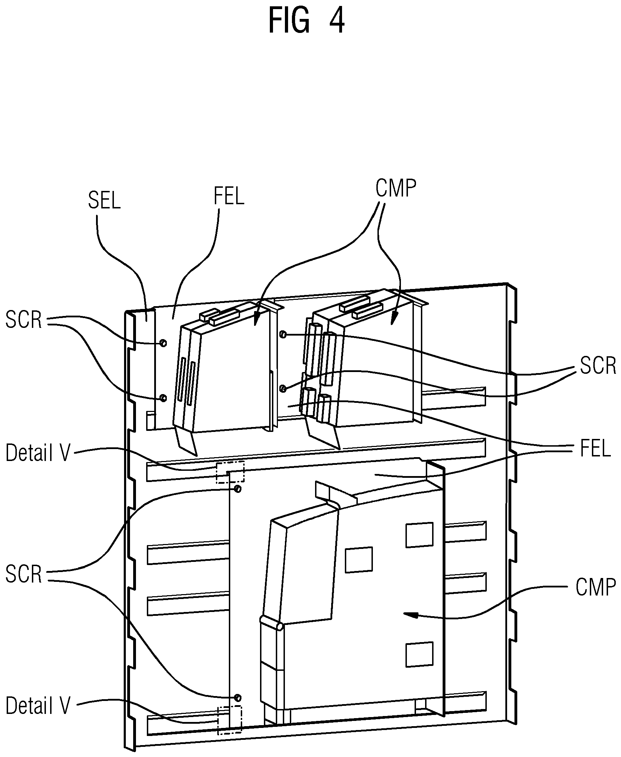

Figur 4 zeigt, wie die drei unterschiedlichen elektrischen Komponenten CMP mit ihren individuell ausgeführten ersten Elementen FEL gemeinsam an einem einzigen zweiten Element SEL angebracht und mittels Schrauben SCR gegen ein Verschieben in Tiefenrichtung bzw. entlang einer zweiten Querrichtung CDR des Haltermoduls MHM gesichert sind.

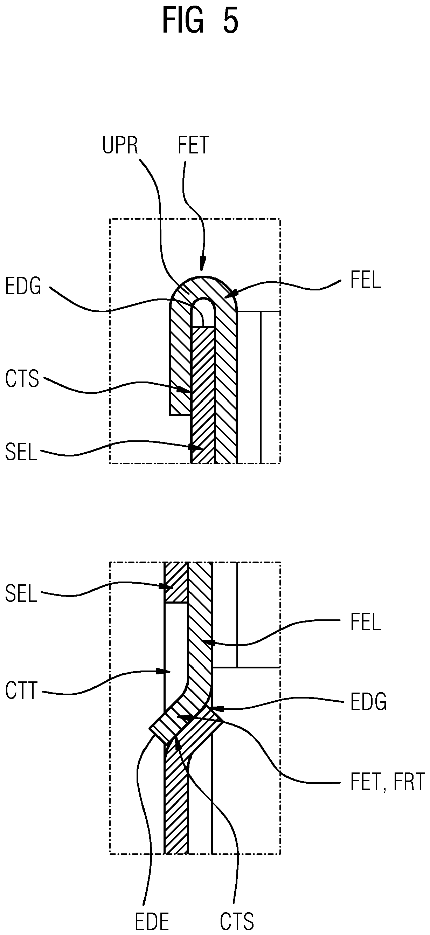

Figur 5 zeigt ausschnittsweise eine Querschnittsdarstellung einer ersten möglichen Ausführungsform im Bereich der Kontaktbereiche CTS des Haltermoduls MHM. Das erste Element FEL und das zweite Element SEL weisen hier zueinander zwei Kontaktbereiche CTS auf, die zur kompakteren Darstellung ohne einen verbindenden Zwischenbereich wiedergegeben sind. Der obere Kontaktbereich CTS ist hierbei anders ausgebildet als der untere Kontaktbereich CTS. Das zweite Element SEL kann sowohl in erster Längsrichtung LTD als auch entgegen der ersten Längsrichtung LTD weiter fortgesetzt sein, was die ausschnittsweise Querschnittsdarstellung nicht wiedergibt.

Die Kontaktbereiche CTS seitens des zweiten Elements SEL sind oben und unten als eine sich entlang der zweiten Querrichtung CRD - also in Tiefenrichtung des Schaltschranks RCK - quer zur ersten Längsrichtung LTD erstreckende Schiene TRC ausbildet. Das erste Element FEL ist mit seinem Kontaktbereich CTS im zusammengesetzten Zustand verschieblich in die erste Querrichtung CRD und in die zweite Querrichtung CDR an einer Beweglichkeit gehindert. Das obere Formelement FET des ersten Elements ist als umgekehrtes U-Profil UPR ausgebildet, das die Kante EDG des Kontaktbereichs CTS des zweiten Elements SEL im zusammengesetzten Zustand zumindest teilweise umschließt.

Das untere Formelement FET des ersten FEL ist als eine zweite Ausformung FRT beginnend an einer quer verlaufenden Kante EDG schräg aus der Ebene herausragende Fortsetzung CNT ausgebildet, die an einer Endkante EDE endet, derart, dass die schräge Fortsetzung CNT im zusammengesetzten Zustand durch die zweite Aufnahme CTT hindurch ragt.

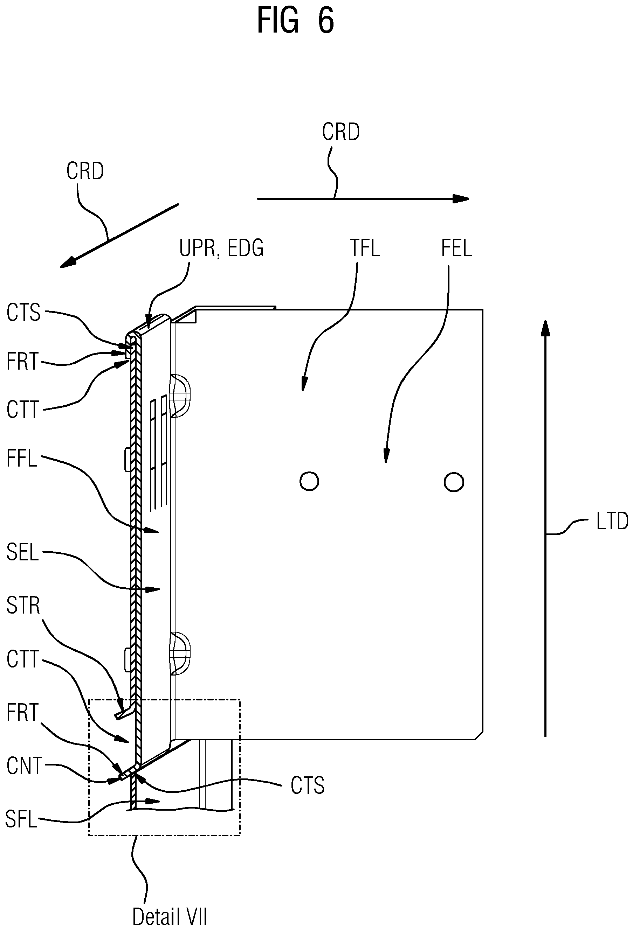

Figur 6 zeigt eine zweite Ausführungsform eines ersten Elements FEL angebracht an einem zweiten Element SEL eines Haltermoduls MHM. Wie in Figur 5 gezeigt, ist auch hier der obere Kontaktbereich CTS mit einem umgekehrten U-Profil UPR seitens des ersten Elements FEL und einer Kante seitens des zweiten Elements SEL ausgeführt.

Das zweite Element SEL weist am unteren Kontaktbereich CTS eine zweite Aufnahme CTT die als Ausnehmung in dem zweiten flächigen Bereich ausgeführt ist. An dem ersten Element FEL ist eine zweite Ausformung FRT vorgesehen, die zu der zweiten Aufnahme CTT an dem zweiten Element SEL korrespondiert. Die zweite Ausformung FRT ist hier identisch mit der in der Figur 5 dargestellten ausgebildet. Die Aufnahme CTT ist hierbei als Ausnehmung gestaltet und weist eine Kante auf, die den Kontakt mit der zweiten Ausformung FRT bildet.

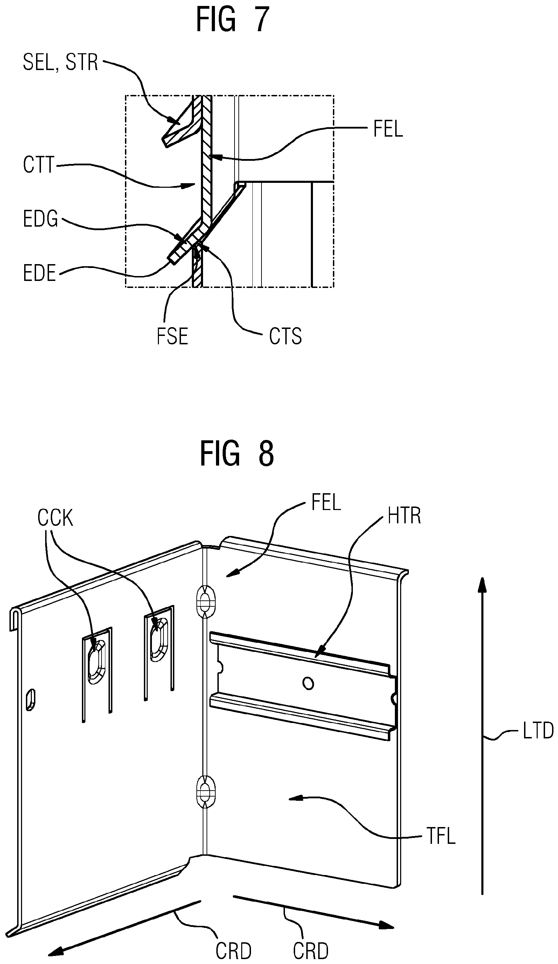

Die Figur 7 zeigt dieses Detail vergrößert. Die Kante ist als Ein als gerader Kantenabschnitt EDG der Aufnahme CTT ausgebildet, der den Kontakt mit der zweiten Ausformung FRT bildet und ist mit einer Fase FSE in einem Winkel versehen, so dass die Ausformung des ersten Elements FEL an der Kante bevorzugt zu einer flächigen Anlage kommt und bei der Montage in die Aufnahme CTT leichter reingleitet. Zur Versteifung weist das zweite Element SEL gegenüberliegend von dem Kontaktbereich CTS eine Kante EDG mit einer sich von der Kante EDG und dem ersten Element FEL fort erstreckenden Versteifungsrippe STR auf, derart, dass der zweite flächige Bereich SFL des zweiten Elements SEL durch diese Versteifungsrippe STR versteift wird.

Figur 8 zeigt das erste Element eines Haltermoduls mit Vorkehrungen zur Befestigung von elektrischen Komponenten CMP. Diese Vorkehrungen sind an einem dritten flächigen Bereich TFL vorgesehen, der sich beginnend an einer sich in die erste Längsrichtung LTD erstreckenden Kante EDG etwa senkrecht zu dem ersten flächigen Bereich FFL erstreckt. Üblicherweise handelt es sich um eine Hutschiene HTR, an der die elektrischen Komponenten CMP schnell und zuverlässig angebracht werden können.

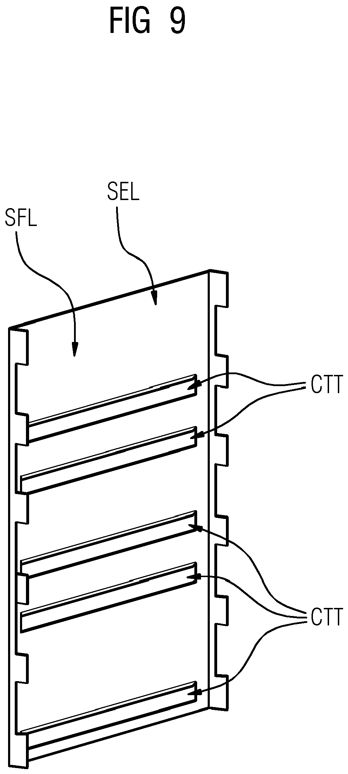

Figur 9 zeigt nochmal ein zweites Elements SEL eines Haltermoduls in unbestückter Ansicht, wie es bereits bestückt in Figur 4 gezeigt ist.

Beispielhaft lässt sich das erfindungsgemäße Verfahren zur Montage elektrischer Komponenten CMP in einen Schaltschrank RCK mit dem Haltermodul MHM anhand der Figuren nachvollziehen. Zunächst wird zweite Element SEL in dem Schaltschrank RCK - siehe Figur 1 - befestigt. Wie in Figur 3 dargestellt werden die elektrischen Komponenten CMP an ersten Elementen FEL angebracht. Anschließend erfolgt ein Anbringen der ersten Elemente FEL umfassend die elektrischen Komponenten CMP an dem zweiten Element - siehe Figur 4 oder Figur 1.

Ein Sichern des ersten Elements FEL an dem zweiten Element SEL gegen ein Verschieben in die zweite Querrichtung CRD und gegen einen Versatz in die erste Längsrichtung LTD ist auch in Figur 4 gezeigt.

## Patentansprüche

1. Modulares Haltermodul (MHM) für elektrische Komponenten (CMP) in einem Schaltschrank (RCK), insbesondere für einen Umrichter eines elektrischen Antriebs (DRV),
wobei die elektrischen Komponenten (CMP) mittels des Haltermoduls (MHM) an einer Seitenbegrenzung (SWL) des Schaltschranks (RCK) befestigbar sind,
**dadurch gekennzeichnet, dass**
- das Haltermodul (MHM) ein erstes Element (FEL) aufweist, an dem mindestens eine elektrische Komponente (CMP) anbringbar ist und
- das Haltermodul (MHM) ein zweites Element (SEL) aufweist, das an einer Seitenbegrenzung (SWL) des Schaltschranks (RCK) anbringbar ist,
- wobei das zweite Element (SEL) und das erste Element (FEL) als Kontaktbereiche (CTS) zueinander korrespondierende Ausformungen (FRT) und/oder Aufnahmen (CTT) aufweisen, die ineinandergreifend ausgebildet sind, so dass das erste Element (FEL) gegen eine Bewegung entgegen einer ersten Längsrichtung (LTD) des Haltermoduls (MHM) abgestützt ist und gegen eine Bewegung entlang einer ersten Querrichtung (CRD) zur ersten Längsrichtung (LTD) durch das Ineinandergreifen der Ausformungen (FRT) und/oder Aufnahmen (CTT) gehindert ist.

2. Haltermodul (MHM) nach Anspruch 1,
wobei ein Kontaktbereich (CTS) des zweiten Elements (SEL) als eine im Wesentlichen sich entlang einer zweiten Querrichtung (CRD) zur ersten Längsrichtung (LTD) erstreckende Schiene (TRC) ausbildet ist, an der das erste Element (FEL) mit seinem Kontaktbereich (CTS) im zusammengesetzten Zustand verschieblich ist, wobei die erste Querrichtung (CRD) und die zweite Querrichtung und die erste Längsrichtung (LTD) jeweils zueinander senkrecht sind.

3. Haltermodul (MHM) nach Anspruch 1 oder 2,
wobei das erste Element (FEL) als Ausformung (FRT) ein Formelement (FET) aufweist, das derart ausgebildet ist, dass es den Kontaktbereich (CTS) des zweiten Elements (SEL), der als Kante (EDG) ausgebildet ist, im zusammengesetzten Zustand zumindest teilweise umschließt.

4. Haltermodul (MHM) nach Anspruch 1, 2 oder 3,
wobei das Formelement (FET) als umgekehrtes U-Profil (UPR) ausgebildet ist, das die Kante (EDG) des Kontaktbereichs (CTS) des zweiten Elements (SEL) im zusammengesetzten Zustand zumindest teilweise umschließt.

5. Haltermodul (MHM) nach einem der vorhergehenden Ansprüche,
wobei das erste Element (FEL) einen ersten flächigen Bereich (FFL) aufweist, und das zweite Element (SEL) einen zweiten flächigen Bereich (SFL) aufweist, so dass im zusammengesetzten Zustand sich der erste flächige Bereich (FFL) und der zweite flächige Bereich (SFL) im Wesentlichen parallel zueinander erstrecken.

6. Haltermodul (MHM) nach einem der vorhergehenden Ansprüche,
wobei das erste Element (FEL) einen dritten flächigen Bereich (TFL) aufweist, der sich beginnend an einer sich in die erste Längsrichtung (LTD) erstreckenden Kante (EDG) etwa senkrecht zu dem ersten flächigen Bereich (FFL) erstreckt.

7. Haltermodul (MHM) nach einem der vorhergehenden Ansprüche,
wobei an dem dritten flächigen Bereich (TFL) Vorkehrungen vorgesehen sind zur Befestigung elektrischer Komponenten (CMP).

8. Haltermodul (MHM) nach einem der vorhergehenden Ansprüche,
wobei ein Kontaktbereich (CTS) des zweiten Elements (SEL) als gerader Kantenabschnitt (EDG) einer Aufnahme (CTT) in einem sich flächig ersteckenden Abschnitt des zweiten Elements (SEL) ausgebildet ist.

9. Haltermodul (MHM) nach einem der vorhergehenden Ansprüche,
wobei das erste Element (FEL) und/oder das zweite Element (SEL) als Blechbauteile ausgebildet sind.

10. Haltermodul (MHM) nach einem der vorhergehenden Ansprüche,
wobei das zweite Element (SEL) und das erste Element (FEL) jeweils mindestens zwei als Kontaktbereiche (CTS) zueinander korrespondierende Ausformungen (FRT) und/oder Aufnahmen (CTT) aufweisen,
wobei eine erste Aufnahme (CTT) an dem zweiten Element (SEL) vorgesehen ist,
wobei eine zweite Aufnahme (CTT) an dem zweiten Element (SEL) vorgesehen ist,
wobei eine erste Ausformung (FRT) an dem ersten Element (FEL) vorgesehen ist, die zu der ersten Aufnahme (CTT) an dem zweiten Element (SEL) korrespondiert, wobei eine zweite Ausformung (FRT) an dem ersten Element (FEL) vorgesehen ist, die zu der zweiten Aufnahme (CTT) an dem zweiten Element (SEL) korrespondiert, wobei das erste Element (FEL) als erste Ausformung (FRT) ein umgekehrtes U-Profil (UPR) aufweist korrespondierend zu einer geraden Kante (EDG) der ersten Aufnahme (CTT), wobei das erste Element (FEL) als zweite Ausformung (FRT) eine beginnend an einer quer verlaufenden Kante (EDG) schräg aus der Ebene herausragende Fortsetzung (CNT) aufweist, die an einer Endkante (EDE) endet, derart, dass die schräge Fortsetzung (CNT) im zusammengesetzten Zustand durch die zweiten Aufnahme (CTT) hindurch ragt.

11. Haltermodul (MHM) nach einem der vorhergehenden Ansprüche,
wobei mindestens eine der Aufnahmen (CTT) in dem zweiten Element (SEL) gegenüberliegend von dem Kontaktbereich (CTS) eine Kante (EDG) mit einer sich von der Kante (EDG) und dem ersten Element (FEL) fort erstreckenden Versteifungsrippe (STR) aufweist, derart, dass der zweite flächige Bereich (SFL) des zweiten Elements (SEL) durch diese Versteifungsrippe (STR) versteift ist.

12. Haltermodul (MHM) nach einem der vorhergehenden Ansprüche,
wobei an dem ersten Element (FEL) und dem zweiten Element (SEL) Vorkehrungen zur Sicherung des ersten Elements (FEL) gegen ein Verschieben in die zweite Querrichtung (CRD) und gegen einen Versatz in die erste Längsrichtung (LTD) vorgesehen sind.

13. Verfahren zur Montage mindestens einer elektrischen Komponente (CMP) in einen Schaltschrank (RCK) mit einem Haltermodul (MHM) nach mindestens einem der vorhergehenden Ansprüche,
**gekennzeichnet durch**:
- Befestigen des zweiten Elements (SEL) in dem Schaltschrank (RCK),
- Befestigen der mindestens einen elektrischen Komponente (CMP) an dem ersten Element (FEL),
- Anbringen des ersten Elements (FEL) umfassend die mindestens eine elektrische Komponente (CMP) an dem zweiten Element.

14. Montageverfahren nach Anspruch 13, umfassend:
- Sichern des ersten Elements (FEL) an dem zweiten Element (SEL) gegen ein Verschieben in die zweite Querrichtung (CRD) und gegen einen Versatz in die erste Längsrichtung (LTD).

15. Schaltschrank (RCK) mit einem Haltermodul (MHM) nach mindestens einem der vorhergehenden Ansprüche 1-12.
